# EUROPEAN PATENT SPECIFICATION

(11) **EP 0 921 158 B1**
(45) Date of publication and mention of the grant of the patent: **14.09.2005**
(21) Application number: 98309598.5
(22) Date of filing: 24.11.1998
(51) Int. Cl.: C08L 71/12, C08L 63/00, H05K 1/03

(54) **Poly(phenylene ether) thermoset compositions**
Wärmehärtbaren Zusammensetzungen von Poly(phenylenether)
Compositions thermodurcissables de Poly(phenylene ether)

(30) Priority: 25.11.1997 US 977744
(43) Date of publication of application: 09.06.1999
(73) Proprietor: GENERAL ELECTRIC COMPANY, Schenectady, NY 12345 (US)
(72) Inventor: Yeager, Gary William, Niskayuna, New York 12309 (US); Pan, Yiqun, Clifton Park, New York 12065 (US); TRACY, James Estel, Killbuck, Ohio 44637 (US)
(74) Representative: Szary, Anne Catherine

(56) References cited:
- EP-A- 0 382 312
- EP-A- 0 383 178
- US-A- 5 352 745

## Description

This invention relates to curable poly(phenylene ether) thermoset compositions.

This invention relates to curable poly(phenylene ether) thermoset compositions amenable to melt forming techniques including solventless impregnation of a fibrous reinforcement, solventless film forming, resin transfer molding and the like. The cured compositions are flame retardant and solvent resistant and exhibit excellent electrical and thermal properties, making them ideally suited for applications, such as printed circuit boards, encapsulating resins and the like.

The manufacture of laminates for the circuit board industry initially involves the production of fiber reinforced prepregs (i.e. fibrous reinforcements impregnated with uncured or partially cured resins). Such prepregs are typically layered and cured to form hard laminates which ultimately serve as a base for electric circuitry.

Thus in the production of laminates, impregnation of a resin into a fibrous reinforcement is a key initial step. Generally this process involves dissolution of a desired resin composition into an inert organic solvent to reduce resin viscosity and allow for efficient saturation of the fibrous reinforcement. The impregnated reinforcement is then heated to volatilize the solvent and partially cure the resin mixture. Whereas this method is generally used to manufacture prepregs for the circuit board industry, it has some significant disadvantages. These include 1) the discharge and disposal of large quantities of solvent, 2) the production of voids in the prepreg as a result of incomplete or inadequate volatilization of the solvent and 3) the energy and time required for solvent removal. These environmental, quality and efficiency issues could be addressed by an effective solventless process.

The need to eliminate using solvents in prepreg manufacture has lead to the development of resins amenable to a solventless process and processing equipment for delivery of these resins to fibrous reinforcements. U.S. Patent No. 4,866,134 and Japanese Patent No. (B2) H2-23326 discloses melt processable formulations comprising i) 2,2-bis(4-(3-acryloyloxy-2-hydroxypropyloxy)-3,5-dibromophenyl)propane ii) styrene and iii) curing catalysts which are delivered to a fibrous glass reinforcement and directly layered and cured with conductive copper outer layers to produce electrical laminates in a continuous process. Furthermore, U.S. Patent Nos. 5,478,593 and 5,492,722 describe processes for the impregnation of fibrous reinforce ments with epoxy resins in the absence of solvents.

Whereas significant advances in the development of solventless compositions and processes for prepreg manufacture have been made, these advance:; are primarily focused on compositions containing essentially monome ic components to produce laminates classified by the National Electrica Manufacturers Association (NEMA) as FR-4 grade. Compositions with improved thermal and electrical properties such as polyphenylene ether containing polyepoxide compositions are increasingly utilized in the laminate industry. There is therefore a need for developing a solventless process for the development of prepreg and laminates.

Poly(phenylene ether)-polyepoxide-polyvinyl compositions useful in printed circuit board applications, have been described in U.S. Patents 5,218,030 and 5,352,745 which disclose the use of poly(phenylene ether)s functionalized with allyl or propagyl groups or by melt reaction with maleic anhydride.

U.S. Patent No. 5,218,030 describes the use of (i) a poly(phenylene ether) containing allyl or propargyl groups, (ii) triallylcyanurate or triallylisocyanurate, and optionally (iii) a flame retardant, or (iv) an antimony-containing auxiliary flame retardant. However the cured resin composition in each of these examples exhibits poor solvent resistance, so that the curable composition is not useful in circuit board applications.

U.S. Patent No. 5,352,745 discloses that compositions with improved solvent resistance may be generated by using a high molecular weight functionalized poly(phenylene ether) resin (η = 0.30-0.56 IV PPO) produced through reactive extrusion of poly(phenylene ether) with maleic anhydride. Formulation of (i) the reaction product of poly(phenylene ether) (PPE) with an unsaturated acid or acid anhydride with, (ii) triallylcyanurate or triallylisocyanurate, (iii) a brominated epoxy resin, (iv) novolak resins, and (v) a cure catalyst, produced flame retardant and solvent resistant resins useful in the production of printed circuit boards. The requirement of functionalization of the PPE resin with maleic anhydride, through extrusion, to achieve solvent resistant laminates imparts an additional level of complexity to the formulation process, which if eliminated, would allow for a more efficient process.

Advances have been made towards the development of flame retardant and solvent resistant poly(phenylene ether)-polyvinyl polyepoxy curable compositions. However the compositions useful for circuit board applications require functionalization (i.e. allylation, propargylation or melt grafting of maleic anhydride) of the poly(phenylene ether) raw material. Elimination of this functionalization step is critical to the development of a more efficient process. Furthermore, the development of flame retardant and solvent resistant poly(phenylene ether) thermosetting formulations amenable to melt forming techniques such as solventless prepreg manufacture have not been described.

It has surprisingly been found that by using compositions comprising a low molecular weight poly(phenylene ether) (PPE) in conjunction with an allylic compound, a brominated epoxy compound, and at least one of a curing agent(s) or curing catalyst(s) for the epoxy and vinylic components, which are well suited to melt forming techniques such as solventless impregnation of a fibrous reinforcement, the compositions so obtained are both solvent resistant and flame retardant with excellent thermal, electrical properties, and dimensional stability. The resin compositions have an additional advantage over known compositions in that they do not require prefunctionalization of the poly(phenylene ether) raw material. The curable compositions described herein, being ameanable to solventless prepreg manufacture, yield the corresponding environmental, quality and efficiency benefits ascribed to such compositions.

### SUMMARY OF THE INVENTION

The present invention relates to a curable poly(phenylene ether) (PPE) containing composition amenable to melt forming techniques, such as solventless prepreg manufacture. The composition comprises a PPE having a number average molecular weight of from about 3,000 to about 15,000 g/mol, at least one allylic compound having the formula IX or X, 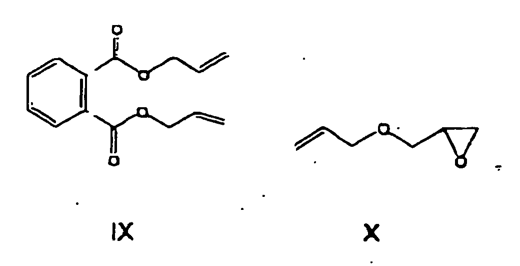 at least one of a brominated epoxy compound and a mixture of a brominated and non-brominated epoxy compound, and at least one of a cure catalyst and a curing agent.

Ar other aspect of the present invention provides a composition comprisir g a PPE having a number average molecular weight of from about 3,000 to about 15,000 g/mol, at least one allylic compound, a brominated epoxy compound, at least one of a cure catalyst and a curing agent, and a reinforcing material.

The curable compositions of the present invention are generally flame retardant and solvent resistant. They exhibit excellent electrical and thermal properties and dimensional stability, making them ideally suited for electrical applicatic ns, such as printed circuit boards.

### DETAILED DESCRIPTION OF THE INVENTION

A preferred embodiment of the present invention provides a composition wherein the PPE comprises from about 2% to about 60% by weight of the total composition, the at least one allylic compound comprises from about 40% to about 80% by weight of the total composition, the at least one of a brominated epoxy compound and a mixture of a brominated and non-brominated epoxy compound comprises from about 0.01% to about 40% by weight of the total composition; and at least one of the cure catalyst or the curing agent comprises from about 0.01% to about 6% by weight of the total composition. A further preferred embodiment provides a composition wherein PPE has a number average molecular weight of less than about 10,000, the preferred PPE being poly(2,6-dimethyl-1,4-phenylene ether) or poly(2,6-dimethyl-1,4-phenylene-co-2,3,6-trimethyl-1,4-phenylene ether).

Another preferred embodiment provides a composition wherein the brominated compound is a glycidyl ether of a brominated bisphenol or a glycidyl ether of a brominated multifunctional phenol, the preferred brominated compound being a glycidyl ether of tetrabromo bisphenol-A or 2,2',6,6'-tetramethyl-3,3',5,5'-tetrabromobisphenol, or a brominated phenolic resin.

For compositions comprising reinforcing materials preferred embodiments comprise PPE from about 2% to about 60% by weight of the total composition, the allylic compound from about 5% to about 65% by weight of the total composition, the brominated epoxy compound comprises from about 0% to about 40% by weight of the total composition, the at least one of the cure catalyst or the curing agent from about 0.01% to about 10% by weight of the total composition, and the reinforcing material from about 10% to about 75% by weight of the total composition. The preferred reinforcing material is an inorganic material or organic material, more particularly E-glass.

The PPE component of the instant invention typically comprises at least one of a plurality of structural units represented by at least one of Formulas I, II, III, IV. V, and VIII: 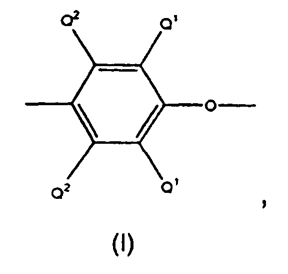 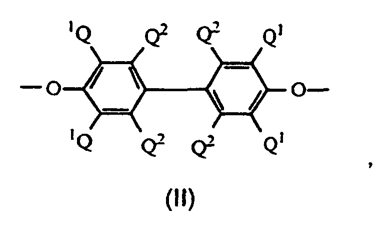 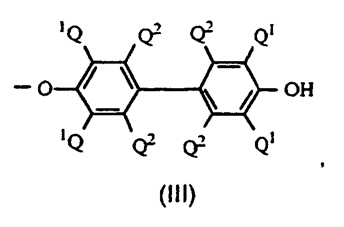 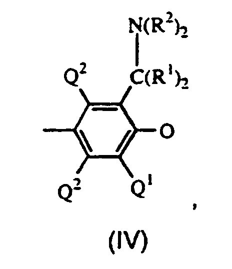 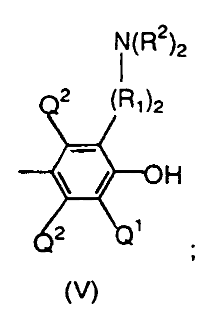 or 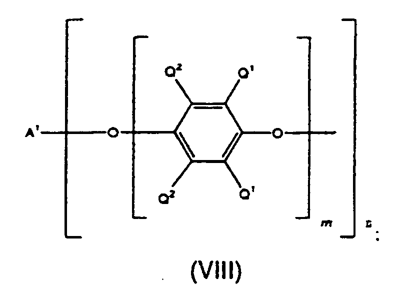 wherein Q¹ and Q² independently represent hydrogen, halogen, alkyl, aryl, mixed alkyl-aryl hydrocarbons, alkoxy, or thioalkyl; R¹ at each occurrence independently represents hydrogen, C₁₋₁₀ alkyl, or C₆₋₁₀ aryl; R² at each occurrence is independently hydrogen, or C₁₋₂₀ alkyl, preferably a C₁-C₁₀ alkyl, n represents an integer from about 1 to about 5, and m represents an integer from about 5 to about 100.

PPE as used in the present invention is generally prepared by oxidative polymerization. A variety of catalysts can be used for the preparation of PPE's via oxidative polymerization. Illustrative examples of catalysts are those that contain at least one heavy metal such as copper, manganese, or cobalt. A preferred catalyst system comprises a copper containing compound. Illustrative examples of such catalysts are as disclosed in U.S. Patent Nos. 3,306,874, 3,306,875, 3,914,266 and 4,028,341, and are incorporated herein by reference.

The PPE component represented by structural Formulas II and III generally are produced by reaction of a poly(phenylene ether) with a diphenoquinone. Reactions between PPE's and diphenoquinones yielding incorporated biphenylene units of structures II and III can occur during polymerization or in subsequent processing steps.

Structural units of Formula IV and V are often observed in poly(phenylene ether)s prepared by oxidative polymerizations carried out in the presence of an amine, preferably a primary or secondary amine, using a copper or manganese containing catalyst. Preferred are structures wherein R¹ is hydrogen and R² independently represents a C₁₋₁₀ alkyl. Numerous beneficial effects, including increased impact strength and compatibilization, have been ascribed to compositions comprising a plurality of structural units of Formulae IV and V, as discussed in U.S. Patent Nos. 4,054,553, 4,092,294, 4,477,651, and 4,517,341, which are incorporated herein by reference.

Other PPE polymers useful in the present invention include those that are formed by oxidative copolymerization of phenols, illustrative examples are 2,6-dimethylphenol and 2,3,6-trimethylphenol. Such copolymers are generally classified as poly (2,6-dimethyl-1,4-phenylene-*co*-2,3,6-trimethyl-1,4-phenylene ether)s. These materials are known to have higher glass transition temperatures than poly(2,6-dimethyl-1,4-phenylene ether), and are expected to impart these properties to the resulting thermoset blend. Also included within this class of polymers are those produced by copolymerization of a phenol such as 2,6-dimethylphenol and a bifunctional phenol such as 2,2-bis(3,5-dimethyl-4-hydroxyphenyl)propane, so as to produce a bifunctional polymer.

Brominated derivatives of PPE's, prepared by addition of bromine to an organic solution of the PPE, are included in the instant invention. Whereas such brominated derivatives may also be produced by direct bromination of a preformed PPE, they may also be prepared by polymerization of an appropriately halogenated monomer or copolymerization of said monomer with another monomer. Typical examples of such processes would include the homopolymerization of 3,4-dibromo-2,6-dimethylphenol or its copolymerization with 2.6-dimethylphenol by means known to one skilled in the art.

For the purposes of this invention, low molecular weight PPE's are desirable. PPE's used in the instant invention typically have an intrinsic viscosity of between about 0.07 and about 0.29 dl/g, as measured in chloroform at 25°C. Further preferred PPE's have intrinsic viscosities of between 0.09 and 0.20 dl/g. The PPE's useful in the present invention have number average molecular weights of between about 1,000 and about 15,000 g/mol, and preferably between about 3,000 and about 12,000 g/mo, as measured by gel permeation chromatography.

Another method of making low molecular weight PPE's is redistribution of a phenolic compound (i.e. a compound containing at least one phenolic hydroxyl group) represented by Formula VI, in the presence of an agent capable of reacting with a PPE so as to generate phenoxy radicals at PPE phenolic end groups:

A¹⁅OH]_{*n*} VI

wherein A¹ is C₆-C₁₀ aryl, optionally substituted with C₆-C₁₀ aryl, C₁-C₂₀ alkyl, C₁-C₂₀ alkoxy, thio C₁-C₂₀ alkyl, C₆-C₁₀ aryloxy, thio C₆-C₁₀ aryl, C₆-C₁₀ aryl sulfonyl, or C₆-C₂₀ mixed aromatic-aliphatic hydrocarbon; and n represents an integer from 1 to 5.

Typical compounds represented by Formula VI are 2- or 3- or 4-methylphenol, 2,3-xylenol, 2,4-xylenol, 2,5-xylenol or 2,6-xylenol, 2,4,6-trimethylphenol, 2-methyl-6-allylphenol, 2- or 3- or 4-methoxyphenol, 2-methoxy-4-allylphenol, 2-allylphenol and bisphenols including 2,2-bis(4-hydroxyphenyl)propane, 2,2-bis(4-hydroxy-3-methylphenyl)propane, 2,2-bis(3,5-dimethyl-4-hydroxyphenyl)propane, 1,1-bis(4-hydroxyphenyl)cyclohexane, 1,1-bis(4-hydroxyphenyl)cyclopentane, 2,2-bis(3,5-dibromo-4-hydroxyphenyl)propane, bis(4-hydroxyphenyl)methane, 2,2-bis(3-allyl-4-hydroxyphenyl)propane, 2,2-bis(2-t-butyl-4-hydroxy-5-methylphenyl)propane, 2,2-bis(3-*t*-butyl-4-hydroxy-6-methylphenyl)propane, 2,2-bis(3-*t*-butyl-4-hydroxy-6-methylphenyl)butane, 1,3-bis(4-hydroxyphenyl-1-(1-methylethylidine)) benzene, 1,4-bis(4-hydroxyphenyl-1-(1-methylethylidine))benzene, 1,3-bis(3-*t*-butyl-4-hydroxy-6-methylphenyl-1-(1-methylethylidine))benzene, 1,4-bis(3-*t*-butyl-4-hydroxy-6-methylphenyl-1-(1-methylethylidine))benzene, 4,4'-biphenol, 2,2',6,6'-tetramethyl-3,3',5,5'-tetrabromo-4,4'-biphenol. 2,2',6,6'-tetramethyl-3,3',5-tribromo-4,4'-biphenol, 4,4-bis(4-hydroxyphenyl)heptane, 1,1-bis(4-hydroxyphenyl)-2,2,2-trichloroethane, 2,2-bis(4-hydroxyphenyl-1,1,13,3,3-hexafluoropropane, 1,1-bis(4-hydroxyphenyl)-1-cyanoethane, 1,1-bis(4-hydroxyphenyl)dicyanomethane, 1,1-bis(4-hydroxyphenyl)1-cyano-1-phenylmethane, 2,2-bis(3-methyl-4-hydroxyphenyl)propane, 1,1-bis(4-hydroxyphenyl)norbornane, 9,9-bis(4-hydroxyphenyl)fluorene, 3,3-bis(4-hydroxyphenyl)phthalide. 1,2-bis(4-hydroxyphenyl)ethane, 1,3-bis(4-hydroxyphenyl)propenone, bis(4-hydroxyphenyl) sulfone, bis(4-hydroxyphenyl) sulfide, 4,4-oxydiphenol, 2,2-bis(4-hydroxy-3-methylphenyl)propane, 2,2-bis(3,5-dimethyl-4-hydroxyphenyl)propane, 4,4-bis(4-hydroxyphenyl)pentanoic acid, 4,4-bis(3,5-dimethyl-4-hydroxyphenyl)pentanoic acid, 2,2-bis(4-hydroxyphenyl) acetic acid, hydroquinone, rescorcinol and the like.

Agents capable of reacting with PPE's so as to produce phenoxy radicals at the phenolic end groups of the PPE are represented by Formula VII:

A²-O-O-A² VII

wherein A² at each occurrence is independently hydrogen, alkyl, aryl, aroyl, alkanoyl, alkenoyl, alkoxycarbonyl, sulfuryl, sulfonyl, or phosphoryl.

Typical of compounds represented by Formula VII are diacyl peroxides such as benzoylperoxide, 4,4-di-*t*-butylbenzoyl peroxide or other aryl substituted derivatives, dilauryl peroxide, acetyl benzoylperoxide, acetyl cyclohexylsulfonyl peroxide or diphthaloyl peroxide, peroxydicarbonates such as diacetylperoxydicarbonate, peroxyacids such as perbenzoic acid, 3-chloroperbenzoic acid, 4-nitroperbenzoic and other substituted derivatives of perbenzoic acid, peroxyacetic acid peroxypropanoic acid, peroxybutanoic acid, peroxynonanoic acid, peroxydodecanoic acid, diperoxyglutaric acid, diperoxyadipic acid, diperoxyoctanedioic acid, diperoxynonanedioic acid, diperoxydodecandioic acid, monoperoxyphthalic acid, as well as inorganic peroxyacids such as peroxysulfuric, peroxydisulfuric, peroxyphosphoric, peroxydiphosphoric and their corresponding salts and peroxycarboxylic esters such as t-butylperformate, t-butyl peracetate, *t*-butyl peroxyisobutyrate, *t*-butylperbenzoate, cumyl perbenzoate, *t*-butyl peroxynonanoate, *t*-butylmonoperoxymaleate, t-butylmonoperoxyphthalate, di-*t*-butyl diperoxyadipates, and 2,5-dimethyl-2,5-bis(benzoylperoxy)hexane.

Other radical producing agents useful in the present invention are quinones or diphenoquinones such as benzoquinone or preferably 2,2',6,6'-tetramethyldiphenoquinone (TMDQ).

When a phenolic compound represented by Formula VI is redistributed with a PPE, a compound represented by Formula VIII is formed wherein Q¹, Q^{2,} A¹, and n are as previously described, and m represents an integer from about 5 to about 100.

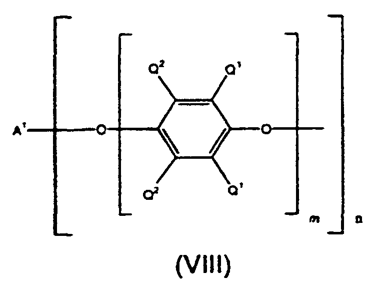

Low molecular weight PPE's can also be prepared by reacting a PPE with a radical producing agent in the absence of a phenolic compound. This would include, for example, the reaction of a PPE with a peroxide such as benzoyl peroxide or the treatment of a PPE with a quinone such as 2,2',6,6' tetramethyl diphenoquinone (TMDQ). The aforementioned structural variations of the PPE are listed to illustrate some of the structures of PPE's that can be used in the instant invention.

From the foregoing, it will be apparent to those skilled in the art that the PPE's contemplated for use in the present invention include all those presently known, irrespective of the method of production, isolation or variations in structural units, ancillary chemical features or modifications.

The allylic compound used in the instantly claimed composition is generally capable of undergoing a cross linking reaction, and is represented by Formula IX or X,
or

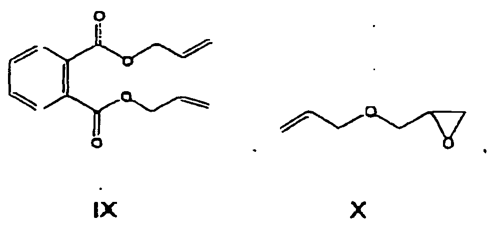

The epoxy or the brominated epoxy compound useful in the present invention is a compound comprising a epoxy residue and a bromine radical. Typical tc this family of compounds are compounds represented by Formula XIII: 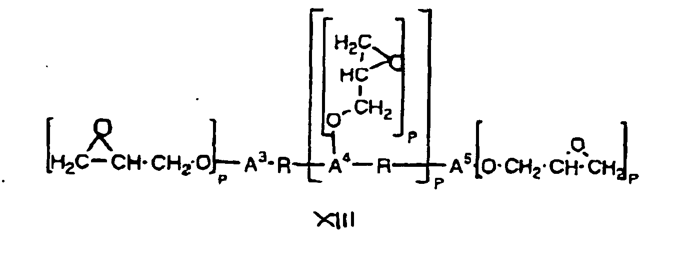 wherein A³-A⁵ independently represent C₆-C₁₀ aryl or bromine containing C₆-C₁₀ aryl residues, each optionally substituted with C₁₋₁₀ alkyl, C₆₋₁₀ aryl, mixed C₆₋₂₀ aromatic-aliphatic hydrocarbons, alkoxy, thio C₁₋₁₀ alkyl, alkenyl. oxygen, halogen, nitrogen, sulfur, or phosphorus; R represents a C₁₋₅₀ hydrocarbon; "p" at each occurrence independently represents an integer from about 1 to about 100, preferably from 1 to about 5.

Illustrative examples of compounds represented by Formula XIII are glycidyl ethers of brominated phenolic resins, glycidyl ethers of brominated phenol-formaldehyde Novolak, sold under the tradename BREN® by Nippon Kayaku. Other bromine containing Novolaks, known to one skilled in the art, will also have utility in the present invention. For example the glycidyl ethers of brominated cresol-formaldehyde novolak, brominated napthol-formaldehyde novolak, or brominated napthol-phenol-formaldehyde novolak and also be used. These materials impart improvements in thermal performance, reductions in resin flow and improvements in electrical properties. The glycidyl ethers of brominated phenol-dicyclopentadiene novolak and brominated phenol-polybutadiene novolak impart improvements in electrical properties, toughness and/or reductions in resin flow, moisture absorption and other related properties.

Brominated epoxy compounds, as used herein, includes mono- and difunctional epoxy compounds. Illustrative examples of monofunctional epoxy compounds are brominated phenyl glycidyl ethers, such as brominated phenylglycidyl ether, brominated cresylglycidyl ether, and brominated napthylglycidyl ethers.

The difunctional epoxy or the brominated difunctional epoxy component is represented by compounds of Formula XIV, wherein A⁶-A⁹ are independently C₆-C₁₀ aryl, or bromine containing C₆₋₁₀ aryl residues, each optionally substituted with C₁₋₁₀ alkyl, C₆₋₁₀ aryl, mixed C₆-C₂₀ aromatic-aliphatic hydrocarbons, C₃₋₁₀ alkoxy, thio C₁₋₁₀ alkyl, C₂₋₈, alkenyl, oxygen, halogen, nitrogen, sulfur, or phosphorus, such that at least one of the A⁶-A⁹ residues contains at least one tromine group; Y is a single bond, C₅-C₁₂ cycloalkyl, n-C₁-C₆ alkyl, C₄-C₇ branched alkyl, O, S, SO or SO₂; and q represents an integer from 0 to about 100.

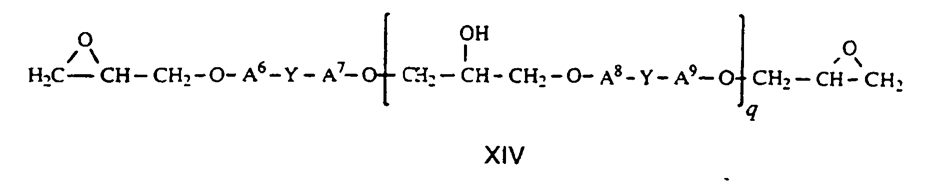

Illustrative examples of compounds represented by Formula XIV are:
(1) The diglycidyl ethers produced by condensation of epichlorohydrin with a bisphenol, where q=0. Typical of this class of compounds are the diglycidyl ethers of 2,2-bis(3,5-cibromo-4-hydroxyphenyl)propane, 2,2',6,6'-tetramethyl-3,3',5,5'-tetrabromo-4,4'-biphenol, 2,2',6,6'-tetramethyl-3,3',5-tribromo-4,4'-biphenol;
(2) The reaction products of brominated bisphenol diglycidyl ethers with bisphenols, or the reaction products of bisphenol diglycidyl ethers with brominated bisphenols. Typical examples include the condensation product of a 2,2-bis(3,5-dibromo-4-glycidyloxyphenyl)propane with 2,2-(4-hydroxyphenyl)- propane, or the condensation product of 2,2-(4-glycidyloxyphenyl) propane with 2,2-bis(3,5-dibromo-4-glycidoxyphenyl)propane tetrabromobisphenol-A.

Partial condensation products suitable for use in the compositions of the instant invention may be prepared by heating a mixture of compounds, as described above, at a temperature range of from about 50°C to about 225°C, preferably from about 100°C to about 190°C, in the presence of a catalytic amount of at least one basic reagent, such as a copper amine, phosphine or a metal salt. Triarylphosphines, especially triphenylphosphine, are the preferred reagents for the bisphenol-bis epoxide condensation reaction. They are usually employed in the amount of from about 0.1% to about 0.5% by weight of the reactants taken together. The reaction is preferably conducted in an inert atmosphere such as nitrogen, especially when a triarylphosphine is employed as the catalyst. An aromatic hydrocarbon solvent such as toluene may be employed, but is not critical.

The brominated epoxy component(s) are used in a way so as to impart sufficient flame retardancy to the thermoset resin. If a UL-94 V-0 rating is desired, it is preferred that the brominated epoxy components be used at levels such that the total bromine content exceeds about 10% by weight of the curable composition. To achieve good solvent resistance it is also preferred that the brominated multifunctional epoxy compound be present at levels exceeding about 10% by weight of the poly(phenylene ether).

The curable composition of the present invention contains both allylic and epoxy resins and may be cured for example, by heating. In the curing process, cross linking of both the epoxy and allylic resins with the poly(phenylene ether) occurs generating a hard laminate. In order to lower the reaction temperature and to promote the crosslinking reaction, inclusion of catalysts to accelerate the cure of both the vinylic and epoxy components is preferred.

The curing agent(s), as used in the instant invention, include agents useful for the cure of epoxy resins, and in particular compositions containing poly(phenylene ether) and epoxy resins. Such cure catalyst(s) and curing agent(s) are generally well known to one skilled in the art and are described in numerous patents and literature accounts. Thus, cure catalysts and cure agents described in *Chemistry and Technology of Epoxy Resins* edited by Bryan Ellis, Published by Blackie Academic and Professional Press an imprint of Chapman Hall Publishers © 1993 are relevant and are incorporated herein by reference.

Cure catalysts useful in the present invention include a compound capable of producing radicals at elevated temperatures. This includes both peroxy, and non-peroxy based radical initiators. Illustrative examples of peroxy initiators useful in the present invention are 2,5-dimethylhexane-2,5-dihydroperoxide, 2,5-dimethyl-2,5-di(t-butylperoxy)-hex-3-yne, di-t-butylperoxide, t-butylcumyl peroxide, α,α'-bis(t-butylperoxy-m-isopropyl)benzene, 2,5-dimethyl-2,5-di(t-butylperoxy)hexane, dicumylperoxide, di(t-butylperoxy isophthalate, t-butylperoxybenzoate, 2,2-bis(t-butylperoxy)butane, 2,2-bis(t-butylperoxy)octane, 2,5-dimethyl-2,5-di(benzoylperoxy)hexane, di(trimethylsilyl)peroxide, and trimethylsilylphenyltriphenylsilyl peroxide and the like. Illustrative examples of non-peroxy radical initiators are 2,3-dimethyl-2,3-diphenylbutane, 2,3-trimethylsilyloxy-2,3-diphenylbutane and the like.

Whereas it is preferred that cure catalyst(s) and/or curing agent(s) for both epoxy and vinylic cure reactions be present, cure catalyst(s) and/or curing agent(s) for only one of the two thermosetting components may be present. The unactivated component can be cured through, for example, heating or other methods known to one skilled in the art, including those described herein. Additives such as Sb₂O₃, Sb₂O₅, NaSbO₃·1/4H₂O can be added to improve the fire retardant properties of the compositions of the instant invention.

Included in the compositions of the instant invention are curable compositions wherein, a filler or an additive may be incorporated in order to impart additional desired properties to the curable composition. Representative examples of fillers include carbon black, silica, alumina, talc, mica, glass beads, hollow glass beads and the like. Representative examples of additives include antioxidants, plasticizers, pigments, dyes, colorants, and the like. Furthermore an additional thermoset or thermoplastic resin additive may be included, either alone or in combination, for the purpose of improving properties such as toughness, impact strength or thermal stability.

The present invention includes compositions containing a reinforcement to lend structural integrity to the thermoset blend. Reinforcing materials known to one skilled in the art can be used including inorganic and organic reinforcements, such as woven or non-woven glass fabrics of the E-, S- and D-style glass and quartz. They may be in the form of glass roving cloth, glass cloth, glass chopped glass mat, glass surfacing mat, and non-woven glass fabric, ceramic fiber fabrics, and metallic fiber fabrics. In addition, synthetic organic reinforcements are also useful in the present invention and would include organic polymers capable of forming fibers. Illustrative examples of such organic fibers are poly(ether ketone), polyimide benzoxazole, poly(phenylene sulfide), polyesters. aromatic polyamides, aromatic polyimides or polyetherimides, acrylic resins. and poly(vinyl alcohol). Fluoropolymers such as polytetrafluoroethylene can be used in the present invention. Also included are natural organic fibers known to one skilled in the art, including cotton cloth, hemp cloth, and felt, carbon fiber fabrics, and natural cellulosic fabrics such as kraft paper, cotton paper, and glass fiber containing paper. Such reinforcements could be in the form of monofilament or multifilament fibers and could be used either alone or in combination with another type of fiber, through, for example, coweaving or core-sheath, side-by-side, orange-type or matrix and fibril constructions or by other methods known to one skilled in the art of fiber manufacture. They could be in the form of, for example, woven fibrous reinforcements, non-woven fibrous reinforcements, or papers.

Coupling agents, incorporated into the reinforcing material, are known in the art to improve adhesion of the fibrous reinforcement to the cured resin composition. For the purposes of this invention, representative coupling agents are silane-, titanate-, aluminum-, and/or zircoaluminum-based coupling agents and other agents known to one skilled in the art.

The cured composition of the present invention can be used in the form of a film or a laminate structure comprising a metal foil and at least one cured resin composition layer disposed on at least one surface of said metallic foil. Representative metallic foils useful in the present invention are copper foil, aluminum foil and the like. Generally the thickness of the metallic foil is from about 5 mm to about 200 mm, preferably from about 5 mm to 100 mm.

The composition of the present invention is designed to be readily used in melt forming operations, including solventless prepreg manufacture and film forming processes. In the solventless prepreg manufacture the liquid-form curable composition can be applied to a fibrous reinforcement by means such as those described in U.S. Patent Nos. 5,478,599 and 5,492,722. To ensure that the thermosetting resin does not prematurely cure, it is important that the catalysts are well mixed with the resin composition just prior to application of the curable composition to the reinforcing material. Because of the short time frames involved, accurate and consistent metering of the catalyst to the resin mixture is critical. Because of the small quantities of catalyst involved, accurate and consistent metering of the catalyst alone is generally not possible and a carrier resin is often used to overcome this problem. The catalysts are therefore ideally dissolved in a carrier resin, which is unaffected by the presence of the catalyst. In the present invention this is accomplished by dissolving the epoxy cure catalyst(s) and/or curing agent(s) in a solution of poly(phenylene ether) and a vinyl component at elevated temperatures and conversely dissolving the vinyl cure catalyst(s) in a solution of the epoxy component(s). The two solutions are combined in a mix head and then applied to the desired reinforcement.

Such a composition would also be applicable to the continuous generation of laminate such as that described in U.S. Patent No. 4,866,134, wherein the two catalyst-carrier resin solutions described above are mixed just prior to application and impregnation of a reinforcing material. The reinforcing martial is layered with other impregnated reinforcements, layered with copper foil and cured in an oven to form a hard laminate.

The molten resin may also be cast by conventional methods and shaped into a sheet or film. For example the curable composition may be coated or cast to a desired thickness onto substrates including inorganic substrates such as a stainless steel plate, aluminum plate, glass plate or organic substrates such as a polyimide film, polyester film, polyethylene film and the like. If desired, the film thus formed is removed from the substrate or transferred to another substrate and cured at a subsequent stage after it has been shaped into a desired form.

Other methods of shaping the desired curable composition include injection molding, resin transfer molding, extrusion, press molding or the like. The melt molding may generally be carried out at temperatures sufficient to allow for adequate resin flow but lower than a temperature at which significant curing of the resin formulation occurs. Completion of the resin cure may be carried out by, for example, further heating at elevated temperatures after the resin has been shaped into a desired form.

The above mentioned casting method, and heat melting method can be used individually or in combination. For example it is possible that films of the curable composition are cast first, then layered and fused using a melt fabrication method, such as press molding, so as to produce a sheet of the curable composition.

The cured composition may be cured by any of a number of techniques known to one skilled in the art, including heating, exposure to light or an electron beam. When heating is used, a temperature is chosen on the basis of whether a radical initiator or curing agent is used. The temperature selected can be from about 80° to about 300°C, and preferably from about 120° to about 240°C. The heating period can be from about 1 minute to about 10 hours, preferably from about 1 minute to about 6 hours.

As used herein "alkyl" means a C₁₋₁₀ alkyl group, and "aryl" means a C₆₋₁₀ aromatic group. It is understood that the compositions of the instant invention can be used in combination with a reinforcing material which is chosen from E-, S-, or D-style glass, organic reinforcing material or other similar material known to one skilled in the art. The reinforced resins of the instant invention can be layered and cured to form, for example, a circuit board laminate, to encapsulate, enclose or seal electronic devices.

### EXPERIMENTAL

Table 1 lists the molecular weights and intrinsic viscosities of representative PPE's used in the formulation of melt processable poly(phenylene ether)-poly(vinyl)-poly(epoxide) compositions of the present invention:

**Table 1**

| PPE | Method of preparation | Mn (g/mol) | Mw (g/mol) | Intrinsic viscosity (dl/g) |
|---|---|---|---|---|
| | | | | |
| #1 | A | 15,242 | 35,436 | 0.30 |
| #2 | B | 2.684 | 7,378 | 0.13 |
| #3 | C | 4.319 | 12,801 | 0.17 |
| PPE = Poly(phenylene ether) studied; Intrinsic viscosities were determined in chloroform at 25°C; Number average (Mn) and weight average (Mw) molecular weights were determined by gel permeation chromatography and calculated relative to polystyrene standards. | | | | |

### Method A. Oxidative polymerization of 2,6-xylenol: Method B. Oxidative polymerization using 5 mol% of a 2,4,6-trimethylphenol endcap. Method C. Redistribution of a 0.40 IV poly(2,6-dimethyl-1,4-phenylene ether) with 2,2-bis(4-hydroxyphenyl)propane using benzoyl peroxide as the radical forming agent.

Triallylcyanurate, 2-ethyl-4-methylimidazole and 3,5-bis(t-butylperoxy)-3,5-dimethylhex-3-yne), allyl glycidyl ether and zinc octoate were obtained from the Aldrich Chemical company. The brominated, epoxidized phenol-formaldehyde novolak (BREN-S) was obtained from Nippon Kayaku. Tetrabromobisphenol-A diglycidyl ether (DER 542) was obtained from Dow Chemical Company.

### Preparation of melt prepreggable poly(phenylene ether)-polyvinyl-polyepoxy laminates :

A mixture of triallylcyanurate, brominated-epoxidized phenol-formaldehyde novolak and tetrabromobisphenol-A diglyciyl ether were heated to 100°C in a 3-neck round-bottomed flask. With vigorous stirring poly(phenylene ether) resin was added, at a rate so as to avoid agglomeration, to the solution as the reaction mixture was heated to 140°-150°C. After the poly(phenylene ether) had completely dissolved the catalysts (zinc octoate, 2-ethyl-4-methylimidazole and 3,5-bis(t-butylperoxy)-3,5-dimethylhex-3-yne) were added and the solution vigorously stirred for 15-30 seconds. A portion of the resin was then poured onto a strip of a woven or nonwoven reinforcement on a heated plate (140°-160°C) with a doctor blade attachment. The reinforcement was then slowly passed under a doctor blade to remove excess resin. The resulting bead of resin which formed behind the doctor blade was replenished as it was consumed in the impregnation process. The resulting prepregs were then partially cured in an oven at 140°C -170 °C for 30 minutes. The thermoset resin compositions prepared in this manner are listed in Tables 2 and 3.

Six of the resulting reinforced prepregs were layered and heated in a compression mold at 200°C for 3h under a pressure of 10 tons, so as to produce 6-ply laminates. The physical properties of the laminates so produced are shown in Table 2 and 3. In general, the resulting composites exhibited good interlaminar integrity and resistance to methylene chloride. These composites also exhibited excellent dielectric and thermal properties, critical to their use in applications such as printed circuit boards.

**Table 2:**

| Melt-prepreggable poly(phenylene ether)-polyvinyl-polyepoxy thermosetting resins. | | | | | |
|---|---|---|---|---|---|
| **Example** | **1** | **2** | **3** | **4** | **5** |
| PPE Component | Weight % | | | | |
| PPE #3 | 30 | 28 | 25 | | |
| PPE #1 | | | | 25 | |
| PPE #2 | | | | | 25 |
| Cyanurate Component | | | | | |
| Triallylcyanurate(TAC) | 42.7 | 44.7 | 47.7 | 47.7 | 47.7 |
| Brominated Epoxy Component | | | | | |
| Epoxidized bromophenol formaldehyde novolak (BREN®, Nippon Kayaku) | 16.7 | 16.7 | 16.7 | 16.7 | 16.7 |
| Tetrabromobisphenol-A diglycidyl ether (DER 542, Dow Chemical Co.) | 7.5 | 7.5 | 7.5 | 7.5 | 7.5 |
| Curing Agent/Catalyst | | | | | |
| Zinc octoate | 1.47 | 1.47 | 1.47 | 1.47 | 1.47 |
| 2-Ethyl-4-methylimidazole (Ethacure, Ethyl Co.) | 0.2 | 0.2 | 0.2 | 0.2 | 0.2 |
| 2,2-Bis(t-butylperoxy)-3,5-dimethylhex-3-yne (Lupersol 130, Lucidol Co.) | 1.47 | 1.47 | 1.47 | 1.47 | 1.47 |
| **Reinforcement (E-Glass)** | 45 | 37 | 40 | 30 | 31 |
| **Properties** | | | | | |
| Tg (DMA, °C) | 225 | 220 | 233 | 235 | |
| Laminate integrity | good | good | good | good | good |
| z-axis expansion | 2.96 | 3.34 | 2.16 | | |
| MeCl₂ resistance | good | good | good | fair | good |
| Dielectric Constant (1 MHz) | 3.74 | 4.00 | 4.38 | 4.64 | 4.08 |
| Dissipation Factor(1 MHz) | 0.012 | 0.012 | 0.011 | 0.008 | 0.008 |
| Flammability | V-0 | V-0 | V-0 | V-0 | V-0 |

The data in the above table indicates that the PPE thermoset blends possess good thermal properties as indicated by high glass transition temperatures (Tg) of above 200°C, dielectric constant values of about 3.7 to about 4.6, dissipation factor of between about 0.008 and about 0.012, and were flame resistant as indicated by the V0 value in the UL-94 flammability test. PPE #1 exhibited insufficient solvent resistance when exposed to methylene chloride (Example 4). Reducing the molecular weight of the PPE resulted in significant improvement in solvent resistance as indicated by the good methylene chloride resistance for Examples 1-3 and 5-9. The good solvent resistance of compositions comprising low molecular weight PPE's is indicative of the utility of these low molecular weight PPE's in the compositions.

**Table 3.**

| E-glass reinforced, melt-prepreggable poly(phenylene ether)-polyvinyl-polyepoxy thermoset resins. | | | | |
|---|---|---|---|---|
| **Formulation** | **6** | **7** | **8** | **9** |
| | Weight % | | | |
| PPO #3 (equil 0.40) | 30 | 28 | 25 | |
| PPO #2 (MT low) | | | | 25 |
| Cyanurate Component | | | | |
| Triallylcyanurate (TAC) | 32.7 | 34.7 | 37.7 | 37.7 |
| Brominated Epoxy Component | | | | |
| Epoxidized bromophenol formaldehyde novalak (BREN Nippon Kayaku) | 16.7 | 16.7 | 16.7 | 16.7 |
| Tetrabromobisphenol-A diglycidyl ether (DER 542, Dow Chemical Co.) | 7.5 | 7.5 | 7.5 | 7.5 |
| Vinylic Epoxy Component | | | | |
| Allyl glycidyl ether | 10.0 | 10.0 | 10.0 | 10.0 |
| Curing Agent/Catalyst | | | | |
| Zinc octoate | 1.47 | 1.47 | 1.47 | 1.47 |
| 2-Ethyl-4-methylimidazole (Ethacure, Ethyl Co.) | 0.2 | 0.2 | 0.2 | 0.2 |
| 2,2-Bis(t-butylperoxy)-3,5-dimethylhex-3-yne (Lupersol 130, Lucidol Co.) | 1.47 | 1.47 | 1.47 | 1.47 |
| **Reinforcement (E-Glass)** | 42 | 45 | 40 | - |
| **Properties** | | | | |
| Tg (DMA, °C) | 215 | 210 | 225 | 210 |
| Laminate integrity | good | good | good | good |
| z-axis expansion | | | | |
| MeCl₂ resistance | good | good | good | good |
| Dielectric Constant (1 MHz) | 3.79 | 3.87 | 3.85 | - |
| Dissipation Factor(1 MHz) | 0.009 | 0.010 | 0.009 | - |
| Flammability | V-0 | V-1 | V-0 | V-0 |

Poly(phenylene ether)-polyvinyl-polyepoxide laminates shown in Table 4 were prepared as described below.

### Preparation of poly(phenylene ether)-polyvinyl-polyepoxy resin solution

PPE resin (η=0.40 dl/g) was dissolved in toluene and treated with a desired phenol (e.g. bisphenol-A) and a peroxide (e.g. benzoyl peroxide) at 90°C for 90 minutes in toluene. After the reaction was complete the temperature was reduced and the resin mixture formulated with a vinyl resin (either triallyisocynaurate (TAIC) or triallylcyanurate (TAC)), an epoxy resins and catalyst and/or additives or modifiers to a concentration of 50% solids. The thermoset resin compositions studied are shown in Table 4.

### Preparation of poly(phenylene ether)-polyvinyl-polyepoxy laminates

After formulation, the E-glass was impregnated with the resin solution. The resulting impregnated glass fabric was heated at 170°C for 30 minutes to remove solvent and partially cure the thermoplastic-thermoset blend. Six of the resulting reinforced prepregs were layered and heated in a compression mold at 200 °C for 3h under a pressure of 10 tons so as to produce 6-ply laminates. The physical properties of the laminates so produced are shown in Table 4. In general, the resulting composites exhibited good resistance to methyler e chloride. These composites also exhibited excellent dielectric properties, critical to their use in applications such as printed circuit boards.

Tables 4 shows the compositions of the E-glass reinforced PPE-polyvinyl polyepoxy resins and the physical properties of the cured laminates.

The vinyl component of the examples shown in Table 4 is either triallisocyanurate (TAIC) or triallylcyanurate (TAC). As shown in Table 4, TAC produces thermosets with substantially higher Tgs than TAIC. In theory, however, any of a number of vinyl resins known to the art could be used.

To flame retard the thermoset, bromine was incorporated in the form of tetrabromobisphenol-A diglycidyl ether. Whereas this is an effective means of incorporating bromine into the thermoset resin, other brominated resins or additives could also be used. A second epoxy resin used in the present invention is a multifunctional epoxy. As shown in Tables 4 and 5, whereas epoxidized novalacs are a preferred form of the multifunctional epoxy, other multifunctional epoxy resins resins such as 1,1',2,2'-tetrakis(4-glycidoxphenyl)ethane may be used.

**Table 4:**

| PPE-Polyvinyl-Polyepoxy Thermosets. | | | | | | | | |
|---|---|---|---|---|---|---|---|---|
| **Formulation** | **10** | **11** | **12** | **13** | **14** | **15** | **16** | **17** |
| | Weight % | | | | | | | |
| PPO #1 (η=0.40 dl/g) | 29.4 | 29.4 | 29.4 | 29.4 | 29.4 | 29.4 | 29.4 | 29.4 |
| Benzoyl Peroxide (BPO) | 1.18 | 1.18 | 1.18 | 1.18 | 1.18 | 1.18 | 1.18 | 1.18 |
| 2,2-bis(4-hydroxyphenyl)propane | 1.18 | 1.18 | 1.18 | 1.18 | 1.18 | 1.18 | 1.18 | 1.18 |
| Triallylcyanurate (TAC) | - | - | - | 23.90 | 23.90 | 23.90 | 23.90 | 23.90 |
| Triallylisocyanurate (TAIC) | 23.90 | 23.90 | 23.90 | - | - | - | - | - |
| Tetrabromobisphenol-A diglycidyl ether (DER 542, Dow Chemical Co.) | 24.5 | 24.5 | 24.5 | 24.5 | 24.5 | 24.5 | 24.5 | 24.5 |
| 1,1',2,2'-Tetrakis(4-glycidoxyphenyl)ethane (Epon 1031, Shell Chemical Company) | 16.7 | - | - | 16.7 | - | - | - | - |
| Epoxidized cresol-formaldehyde novolac (ECN 1299, CIBA) | - | 16.7 | - | - | 16.7 | - | - | - |
| Epoxidized 2,2-bis(4-hydroxyphenyl) propaneformadehyde novalac (SU-8, Shell Chemical Company) | - | - | 16.7 | - | - | 16.7 | - | - |
| Epoxidized phenol(dicyclopentadiene) novalac | - | - | - | - | - | - | 16.7 | - |
| Epoxidized phenol formaldehyde novalac (EPN 1138, CIBA) | - | - | - | - | - | - | - | 16.7 |
| Zinc octoate | 1.47 | 1.47 | 1.47 | 1.47 | 1.47 | 1.47 | 1.47 | 1.47 |
| 2-Ethyl-4-methylimidazole (Ethacure, Ethyl Co.) | 0.2 | 0.2 | 0.2 | 0.2 | 0.2 | 0.2 | 0.2 | 0.2 |
| 2,2-Bis(t-butylperoxy)-3,5-dimethylhex-3-yne (Lupersol 130, Lucidol Co.) | 1.47 | 1.47 | 1.47 | 1.47 | 1.47 | 1.47 | 1.47 | 1.47 |
| **Reinforcement (E-Glass)** | 28 | 33 | 35 | 33 | 39 | 33 | 30 | 35 |
| **Properties** | | | | | | | | |
| Tg (DMA, °C) | 141 | 149 | 150 | 190 | 215 | 220 | 193 | 192 |
| MeCl₂ resistance | good | good | good | good | good | good | good | good |
| Dielectric Constant (1 MHZ) | 4.95 | 4.40 | 4.00 | 4.60 | 4.10 | 4.50 | 4.30 | 4.70 |
| Dissipation Factor(1 MHz) | 0.008 | 0.006 | 0.006 | 0.012 | 0.009 | 0.009 | 0.007 | 0.008 |
| Flammability | V-0 | V-0 | V-0 | V-0 | V-0 | V-0 | V-0 | V-0 |

## Claims

1. A composition comprising:
(a) a poly(phenylene ether) having a number average molecular weight of 3,000 to 15,000 g/mol;
(b) at least one allylic compound having the formula IX or X. 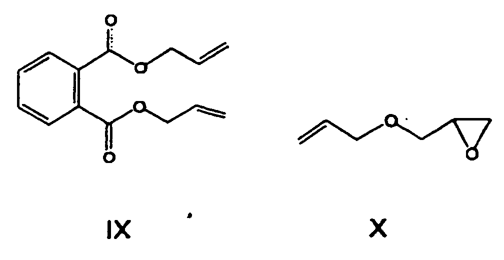
(c) at least one of a brominated epoxy compound and a mixture of a brominated and non-brominated epoxy compound; and
(d) at least one of a cure catalyst and a curing agent.

2. A composition of claim 1 wherein,
(a) the poly(phenylene ether) is from 2% to 60% by weight of the total composition;
(b) the allylic compound comprises from 40% to 80% by weight of the total composition;
(c) at least one of a brominated epoxy compound and a mixture of a brominated and non-brominated epoxy compound comprises from 0.01% to 50% by weight of the total composition; and
(d) at least one of the cure catalyst or the curing agent is from 0.01% to 6% by weight of the total composition.

3. A composition of claim 1 or claim 2, wherein the poly(phenylene ether) comprises a plurality of structural units represented by at least one of Formulae I, II, III, IV, V and VII: 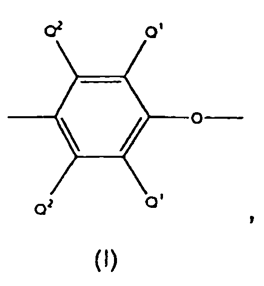 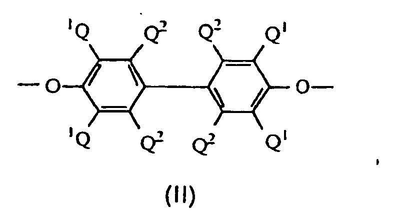 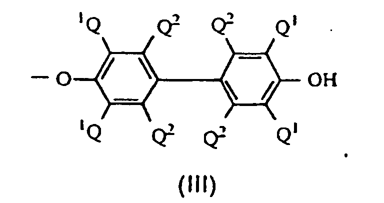 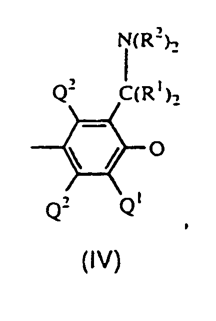 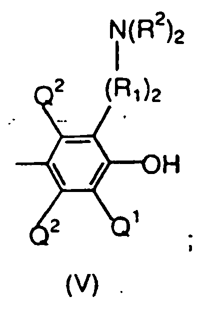 and 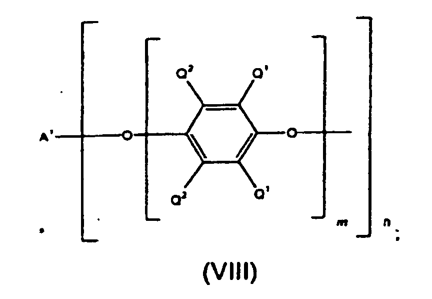 wherein:
Q¹ and Q² independently represent hydrogen, halogen, alkyl, aryl, mixed alkyl-aryl hydrocarbons, alkoxy, or thioalkyl;
R' at each occurrence independently represents hydrogen, C₁₋₁₀ alkyl, or C₆₋₁₀ aryl;
R² at each occurrence is independently hydrogen, or C₁₋₂₀ alkyl, preferably a C₁₋C₁₋₁₀ alkyl;
n represents an integer from 1 to 5; and
m represents an integer from 5 to 100.

4. A composition comprising:
(a) a poly(phenylene ether) having a number average molecular weight of from 3,000 to 15,000 g/mol;
(b) at least one compound comprising at least one allylic functionality having the formula IX or X. 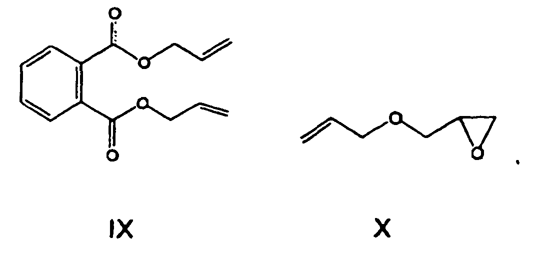
(c) at least of a brominated epoxy compound and a mixture of a brominated and non-brominated epoxy compound;
(d) at least one of a cure catalyst or a curing agent; and
(e) reinforcing material.

5. A composition of claim 4 wherein:
(a) the poly(phenylene ether) comprises from 2% to 60% by weight of the total composition;
(b) the allylic containing compound comprises from 5% to 65% by weight of the total;
(c) at least one of a brominated epoxy compound and a mixture of a brominated and non-brominated epoxy compound comprises from 0.01 % to 50% by weight of the total composition;
(d) the brominated epoxy compound comprises from 0.01% to 40% by weight of the total composition;
(e) the at least one of the cure catalyst or the curing agent comprises from 0% to 10% by weight of the total composition; and
(f) the reinforcing material comprises from 10% to 75% by weight of the total composition.

6. A composition of any preceding claim wherein the poly(phenylene ether) has a number average molecular weight of less than 10,000.

7. A composition of any preceding claim wherein the brominated compound is a glycidyl ether of a brominated bisphenol or a glycidyl ether of a brominated multifunctional phenol.

8. A composition of any preceding claim wherein the poly(phenylene ether) is poly(2,6-dimethyl-1,4-phenylene ether) or poly(2,6-dimethyl-1,4-phenylene-co-2,3,6-trimethyl-1,4-phenylene ether.

9. A composition of any preceding claim wherein the brominated compound is a glycidyl ether of tetrabromobisphenol-A or 2,2',6,6'-tetramethyl-3,3',5,5'-tetrabromobisphenol; or a brominated phenolic resin.

10. A composition of any preceding claim wherein the allylic compound is a diallyl phthalate or an allyl glycidyl ether.

## Patentansprüche

1. Eine Zusammensetzung aufweisend:
(a) einen Polyphenylenether mit einem Zahlenmittel des Molekulargewichts von 3000 bis 15000 g/Mol;
(b) wenigstens eine Allylverbindung mit der Formel IX oder X 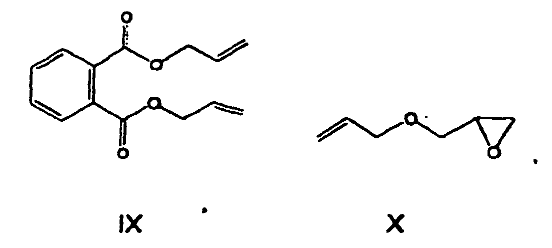
(c) wenigstens eine bromierte Epoxyverbindung und/oder wenigstens eine Mischung aus einer bromierten und nicht-bromierten Epoxyverbindung; und
(d) wenigstens einen Härtungskatalysator und/oder wenigstens ein Härtungsmittel.

2. Eine Zusammensetzung nach Anspruch 1, **dadurch gekennzeichnet, dass**
(a) der Poly(phenylenether) 2 % bis 60 Gew.-% der gesamten Zusammensetzung ausmacht;
(b) die Allylverbindung 40 bis 80 Gew.-% der gesamten Zusammensetzung ausmacht;
(c) wenigstens eine bromierte Epoxyverbindung und/oder wenigstens eine Mischung aus einer bromierten und nicht-bromierten Epoxyverbindung 0,01 % bis 50 Gew.-% der gesamten Zusammensetzung ausmacht; und
(d) der wenigstens eine Härtungskatalysator und/oder das wenigstens eine Härtungsmittel 0,01 % bis 6 Gew.-% der gesamten Zusammensetzung ausmachen.

3. Zusammensetzung nach Anspruch 1 oder Anspruch 2, **dadurch gekennzeichnet, dass** der Poly(phenylenether) eine Vielzahl von Struktureinheiten umfasst, dargestellt durch wenigstens eine der Formeln I, II, III, IV, V und VII: 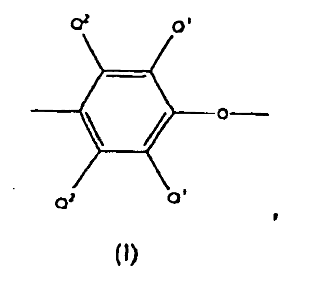 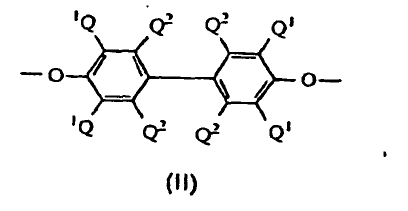 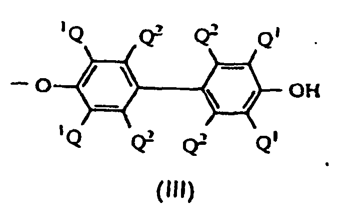 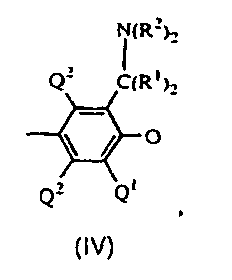 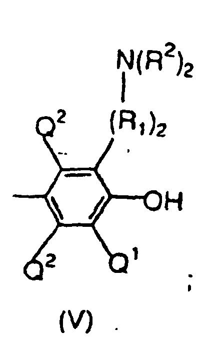 und 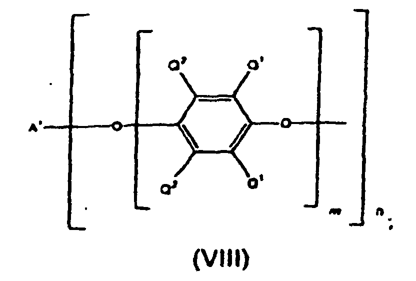 worin:
Q¹ und Q² unabhängig Wasserstoff, Halogen, Alkyl, Aryl, gemischte Alkyl-Aryl-Kohlenwasserstoffe, Alkoxy oder Thioalkyl bedeuten;
R¹ bei jedem Erscheinen unabhängig Wasserstoff, C₁₋₁₀ Alkyl oder C₆₋₁₀ Aryl darstellt;
R² bei jedem Erscheinen unabhängig Wasserstoff, oder C₁₋₂₀ Alkyl, vorzugsweise ein C₁-C₁₋₁₀ Alkyl, darstellt;
n eine ganze Zahl von 1 bis 5 bedeutet; und
m eine ganze Zahl von 5 bis 100 darstellt.

4. Eine Zusammensetzung aufweisend:
(a) einen Poly(phenylenether) mit einem Zahlenmittel des Molekulargewichts von 3 000 bis 15 000 g/mol;
(b) wenigstens eine Verbindung aufweisend wenigstens eine Allyl-Funktionalität mit der Formel IX oder X. 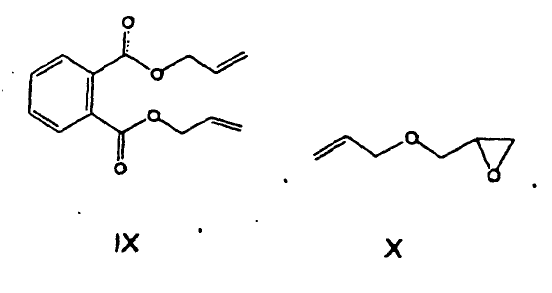
(c) wenigstens eine bromierte Epoxyverbindung und/oder wenigstens eine Mischung von einer bromierten und nicht-bromierten Epoxyverbindung;
(d) wenigstens einen Härtungskatalysator und/oder wenigstens ein Härtungsmittel;
(e) verstärkendes Material.

5. Zusammensetzung nach Anspruch 4, **dadurch gekennzeichnet, dass**:
(a) der Poly(phenylenether) 2 % bis 60 Gew.-% der gesamten Zusammensetzung ausmacht;
(b) die allyl-enthaltende Verbindung 5 % bis 65 Gew.-% des Gesamten ausmacht;
(c) wenigstens eine bromierte Epoxyverbindung und/oder wenigstens eine Mischung aus einer bromierten und nicht-bromierten Epoxyverbindung 0,01 % bis 50 Gew.-% der gesamten Zusammensetzung ausmacht;
(d) die bromierte Epoxyverbindung 0,01 % bis 40 Gew.-% der gesamten Zusammensetzung ausmacht;
(e) der wenigstens eine Härtungskatalysator und/oder das wenigstens eine Härtungsmittel 0 % bis 10 Gew.-% der gesamten Zusammensetzung ausmachen; und
(f) das verstärkende Material 10 % bis 75 Gew.-% der gesamten Zusammensetzung ausmacht.

6. Zusammensetzung nach einem der vorhergehenden Ansprüche, **dadurch gekennzeichnet, dass** der Poly(phenylenether) ein Zahlenmittel des Molekulargewichts von weniger als 10 000 aufweist.

7. Zusammensetzung nach einem der vorhergehenden Ansprüche, **dadurch gekennzeichnet, dass** die bromierte Verbindung ein Glycidylether eines bromierten Bisphenols oder ein Glycidylether eines bromierten mehrfachfunktionellen Phenols ist.

8. Zusammensetzung nach einem der vorhergehenden Ansprüche, **dadurch gekennzeichnet, dass** der Polyphenylenether Poly(2,6-dimethyl-1,4-phenylenether) oder Poly(2,6-dimethyl-1,4-phenylen-co-2,3,6-trimethyl-1,4-phenylenether) ist.

9. Zusammensetzung nach einem der vorhergehenden Ansprüche, **dadurch gekennzeichnet, dass** die bromierte Verbindung ein Glycidylether von Tetrabrombisphenol-A oder 2,2',6,6'-Tetramethyl-3,3',5,5'-tetrabrombisphenol ist; oder ein bromiertes Phenolharz.

10. Zusammensetzung nach einem der vorhergehenden Ansprüche, **dadurch gekennzeichnet, dass** die allylische Verbindung ein Diallylphthalat oder ein Allylglycidylether ist.

## Revendications

1. Composition comprenant :
a) un poly(phénylène éther) dont la masse molaire moyenne en nombre vaut de 3 000 à 15 000 g/mol,
b) au moins un composé allylique de formule IX ou X : 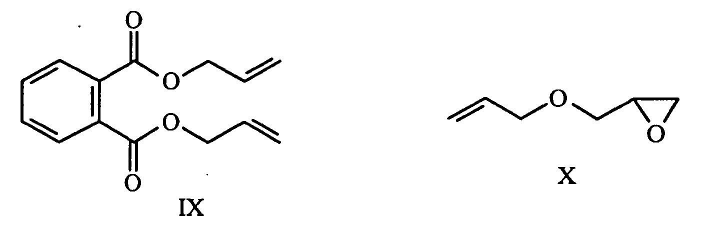
c) au moins l'un d'un composé époxy bromé et d'un mélange de composé époxy bromé et de composé époxy non bromé,
d) et au moins l'un d'un catalyseur de durcissement et d'un agent durcisseur.

2. Composition conforme à la revendication 1, dans laquelle
a) le poly(phénylène éther) représente de 2 à 60 % du poids total de la composition,
b) le composé allylique représente de 40 à 80 % du poids total de la composition,
c) ledit ou lesdits composé époxy bromé et/ou mélange de composé époxy bromé et de composé époxy non bromé représentent de 0,01 à 50 % du poids total de la composition,
d) et ledit ou lesdits catalyseur de durcissement et/ou agent durcisseur représentent de 0,01 à 6 % du poids total de la composition.

3. Composition conforme à la revendication 1 ou 2, dans laquelle le poly(phénylène éther) comporte plusieurs motifs structuraux représentés par au moins l'une des formules I, II, III, IV, V et VIII : 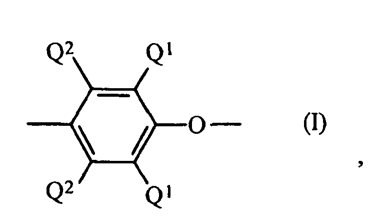 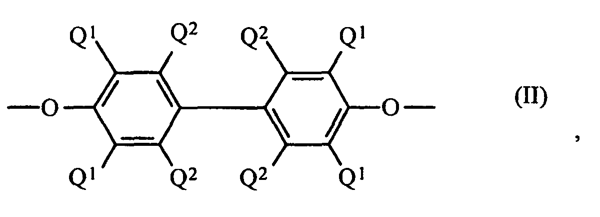 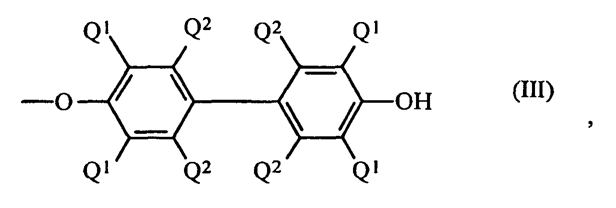 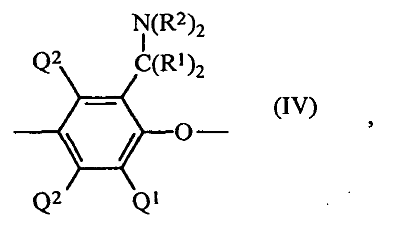 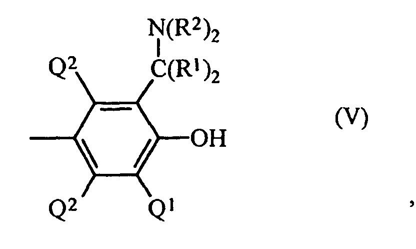 et 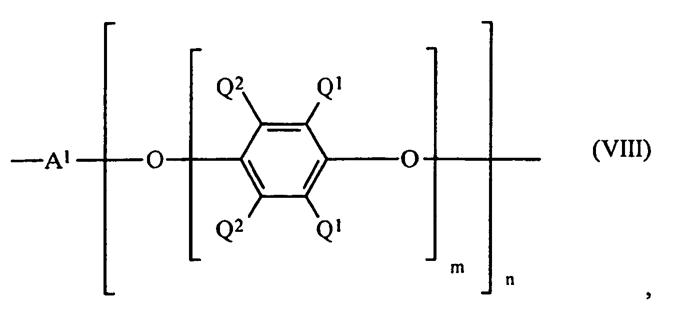 dans lesquelles
Q¹ et Q² représentent chacun, indépendamment, un atome d'hydrogène ou d'halogène ou un groupe alkyle, aryle, hydrocarboné mixte alkylearyle, alcoxy ou alkylthio ;
chaque symbole R¹ représente indépendamment un atome d'hydrogène ou un groupe alkyle en C₁₋₁₀ ou aryle en C₆₋₁₀,
chaque symbole R² représente indépendamment un atome d'hydrogène ou un groupe alkyle en C₁₋₂₀, et de préférence un groupe alkyle en C₁₋₁₀,
A¹ représente un groupe aryle en C₆₋₁₀, portant éventuellement un substituant aryle en C₆₋₁₀, alkyle en C₁₋₂₀, alcoxy en C₁₋₂₀, alkylthio en C₁₋₂₀, aryloxy en C₆₋₁₀, arylthio en C₆₋₁₀, arylsulfonyle en C₆₋₁₀, ou hydrocar-byle mixte aromatique-aliphatique en C₆₋₂₀,
n représente un nombre entier valant de 1 à 5,
et m représente un nombre entier valant de 5 à 100.

4. Composition comprenant :
a) un poly(phénylène éther) dont la masse molaire moyenne en nombre vaut de 3 000 à 15 000 g/mol,
b) au moins un composé comportant au moins un groupe fonctionnel allylique, de formule IX ou X : 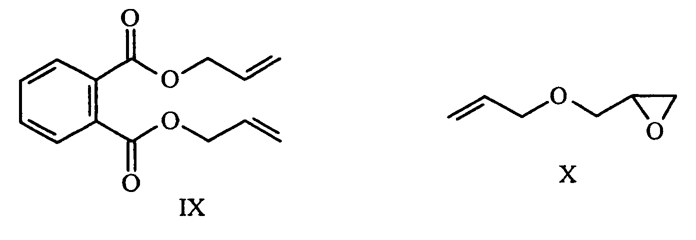
c) au moins l'un d'un composé époxy bromé et d'un mélange de composé époxy bromé et de composé époxy non bromé,
d) au moins l'un d'un catalyseur de durcissement et d'un agent durcisseur,
e) et un matériau de renfort.

5. Composition conforme à la revendication 4, dans laquelle
a) le poly(phénylène éther) représente de 2 à 60 % du poids total de la composition,
b) le composé allylique représente de 5 à 65 % du poids total de la composition,
c) ledit ou lesdits composé époxy bromé et/ou mélange de composé époxy bromé et de composé époxy non bromé représentent de 0,01 à 50 % du poids total de la composition,
d) le composé époxy bromé représente de 0,01 à 40 % du poids total de la composition,
e) ledit ou lesdits catalyseur de durcissement et/ou agent durcisseur représentent de 0 à 10 % du poids total de la composition,
f) et le matériau de renfort représente de 10 à 75 % du poids total de la composition.

6. Composition conforme à l'une des revendications précédentes, dans laquelle la masse molaire moyenne en nombre du poly(phénylène éther) est inférieure à 10 000.

7. Composition conforme à l'une des revendications précédentes, dans laquelle le composé bromé est un éther glycidylique de bisphénol bromé ou un éther glycidylique de polyphénol bromé.

8. Composition conforme à l'une des revendications précédentes, dans laquelle le poly(phénylène éther) est un poly(2,6-diméthyl-1,4-phénylène éther) ou un poly(2,6-diméthyl-1,4-phénylène-co-2,3,6-triméthyl-1,4-phénylène éther)

9. Composition conforme à l'une des revendications précédentes, dans laquelle le composé bromé est un éther glycidylique de tétrabromobisphénol A ou de 2,2',6,6'-tétraméthyl-3,3',5,5'-tétrabromobisphénol, ou une résine phénolique bromée.

10. Composition conforme à l'une des revendications précédentes, dans laquelle le composé allylique est du phtalate de diallyle ou de l'éther de glycidyle et d'allyle.
